Europäisches Patentamt

European Patent Office

Office européen des brevets

(19)

(11) Veröffentlichungsnummer: **0 017 668**
**B1**

(12) **EUROPÄISCHE PATENTSCHRIFT**

(45) Veröffentlichungstag der Patentschrift:
13.04.83

(21) Anmeldenummer: 79105167.5

(22) Anmeldetag: 14.12.79

(51) Int. Cl.³: **H 03 K 19/091**, H 03 K 19/20,
H 01 L 27/08

(54) Programmierbare logische Schaltungsanordnung.

(30) Priorität: 21.03.79 US 22589

(43) Veröffentlichungstag der Anmeldung:
29.10.80 Patentblatt 80/22

(45) Bekanntmachung des Hinweises auf die Patenterteilung:
13.04.83 Patentblatt 83/15

(84) Benannte Vertragsstaaten:
DE FR GB

(56) Entgegenhaltungen:
DE-B-2 141 415
IBM TECHNICAL DISCLOSURE BULLETIN,
Band 18, Nr. 10, März 1976, New York; J. R.
CAVALIERE et al.: »Current Switch Read-Only
Programmable Logic Array«, Seiten 3245 bis 3248.
DER FERNMELDE-INGENIEUR, Band 27, Heft 7,
Juli 1973, Seiten 16 bis 20.
RADIO FERNSEHEN ELEKTRONIK, Band 26,
Nr. 1, 1977, Berlin; Dr. M. AUER et al.: »Komplexe
ECL-Schaltkreise«, Seiten 10 bis 14; Seiten 23 bis
24.

(73) Patentinhaber: International Business Machines
Corporation, Armonk, N.Y. 10504 (US)

(72) Erfinder: Davis, James W., 881 SW 16th St., Boca Raton,
Florida (US)
Erfinder: Jones, Frank D., 17 Kings Drive, Wallkill, New
York 12589 (US)

(74) Vertreter: Rudolph, Wolfgang, Schönaicher Strasse 220,
D-7030 Böblingen (DE)

# Programmierbare logische Schaltungsanordnung

Die Erfindung betrifft eine programmierbare logische Schaltung nach dem Oberbegriff des Anspruchs 1.

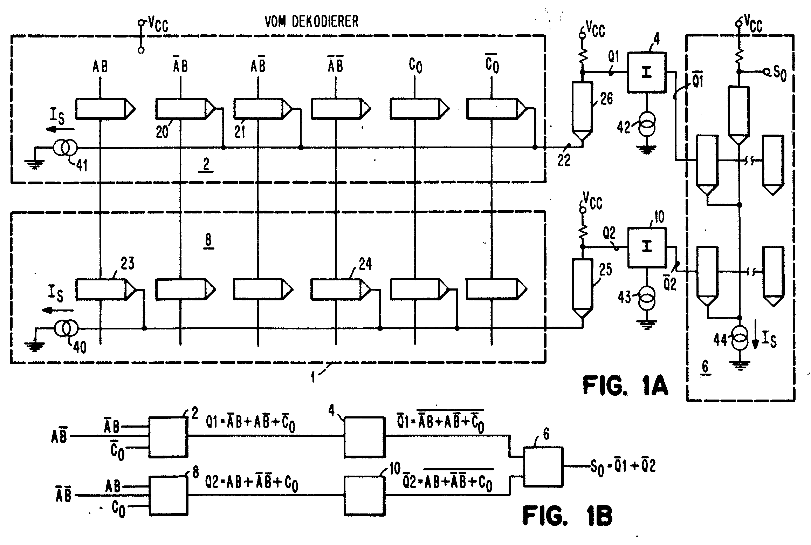

Eine bekannte programmierbare logische Schaltung ist in Fig. 1A und 1B dargestellt; sie ist Gegenstand des IBM-TDBs, Vol. 18, Nr. 10, März 76, Seite 3245. In der Schaltung ist jeder ODER-Block 2 und 8 der Suchgruppe 1 mit einer eigenen Stromquelle 40 oder 41 verbunden. Im ODER-Block 2 sind die Transistoren 20 und 21 in einer Emitterkopplungsschaltung mit dem Transistor 26 verbunden, dessen Kollektor der Ausgangspunkt für diesen ODER-Block ist. Der ODER-Block-Ausgang muß vom Inverter 4 invertiert werden, der wiederum seine eigene Stromquelle 42 hat, und der invertierte Ausgang wird mit dem entsprechenden Ausgang des ODER-Blockes 8 ODER verknüpft. Für diese in Fig. 1A gezeigte herkömmiche Schaltung werden fünf Stromquellen 40, 41, 42, 43 und 44, zwei Inverter 4 und 10 und eine separate Gruppe aus ODER-Schaltungen 6 benötigt, um die PLA-Funktion auszuführen. Die Kollektorspannung $V_{CC}$ wird an die epitaxiale Mulde, die als gemeinsamer Kollektor für den ODER-Block 2 dient, und über einen Widerstand an den Kollektor des Referenztransistors 26 angelegt.

Die Aufgabe der vorliegenden Erfindung besteht daher darin, die Anzahl der in einer bipolaren PLA-Schaltung erforderlichen Stromquellen sowie die von dieser Schaltung für die Ausführung einer gegebenen Funktion belegte Gesamtfläche zu reduzieren und das Geschwindigkeits/Leitungsprodukt für diese Schaltung zu erhöhen.

Diese Aufgabe wird gelöst durch eine integrierte programmierbare logische Schaltungsanordnung (PLA), bestehend aus einem ODER-Block mit einer dazugehörigen Stromquelle und einem Suchgruppen-Block, wobei sowohl die Schaltungen des ODER-Blocks, des Suchgruppen-Blocks als auch der Stromquelle aus bipolaren Transistoren bestehen, dadurch gekennzeichnet, daß jeder Block in seiner eigenen epitaxialen Mulde im Halbleitersubstrat isoliert angeordnet ist, die als gemeinsamer Kollektor für die bipolaren Transistoren dient, daß die Emitter der bipolaren Transistoren in jedem der beiden Blöcke selektiv mit einer für den Block gemeinsamen Emitterleitung verbunden sind, daß die Emitterleitung des ODER-Blocks mit der Stromquelle verbunden ist, daß die Emitterleitung des Suchgruppen-Blocks mit der gemeinsamen Kollektormulde des ODER-Blocks verbunden ist, und daß ein Ausgang an die gemeinsame Kollektormulde des Suchgruppen-Blocks angeschlossen ist, so daß die logische Funktion des ODER-Blocks und diejenige des Suchgruppen-Blocks an dem Ausgang des Suchgruppen-Blocks kombiniert ist.

Auf diese Weise wird eine programmierbare logische Schaltung gebildet, in der weitere in herkömmlichen Schaltungen erforderliche Stromquellen entfallen. Die durch die Schaltung gebildete Phantom-ODER-Schaltung mischt effektiv die herkömmliche ODER-Schaltungsgruppe mit der Suchgruppe.

Ein Ausführungsbeispiel der Erfindung ist in den Zeichnungen dargestellt und wird anschließend näher beschrieben.

Es zeigt

Fig. 1A das Schaltbild einer bekannten PLA-Schaltung,

Fig. 1B das logische Blockdiagramm der in Fig. 1A gezeigten Schaltung,

Fig. 2A das Schaltbild der erfindungsgemäßen PLA-Schaltung,

Fig. 2B in einem Schaltbild im einzelnen die Emitter-Kopplung der in Fig. 2A gezeigten Schaltung und

Fig. 2C in einem logischen Blockdiagramm die in Fig. 2A dargestellte Schaltung.

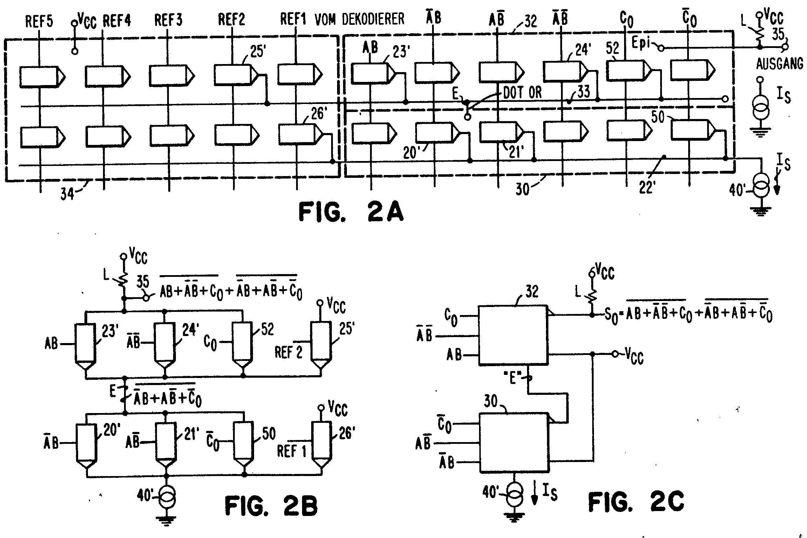

Die erfindungsgemäße PLA-Schaltung ist in den Fig. 2A, 2B und 2C dargestellt. In Fig. 2A sind diejenigen Transistoren, die logische Funktionen entsprechend denen der herkömmlichen Schaltung in Fig. 1A übernehmen, mit einem kleinen Strich versehen, ansonsten entspricht die Transistornumerierung der in Fig. 1A. In Fig. 2A ist der ODER-Block 30 und der Suchgruppen-Block 32, der auch ein ODER-Block ist, in seiner eigenen epitaxialen Mulde isoliert, die als gemeinsamer Kollektor für die Transistoren dient. Die Emitter der bipolaren Transistoren im ODER-Block 32 sind selektiv mit einer Emitterleitung 33 verbunden, die mit der gemeinsamen Kollektormulde des ODER-Blocks 30 gemäß Darstellung in Fig. 2B so verbunden ist, daß die logische der ODER-Schaltungsgruppe 32 und diejenige der ODER-Schaltungsgruppe 30 am Ausgang 35 der ODER-Schaltungsgruppe 32 kombiniert wird, wie es in Fig. 2C gezeigt ist.

Wie deutlicher aus Fig. 2B zu ersehen ist, liefert die Anordnung der bipolaren Transistoren eine stromgeschaltete logische Verbindung worin die parallele Gruppe der Transistoren 20', 21' und 50 im unteren ODER-Block 30 mit der parallelen Gruppe der Transistoren 23', 24' und 52 im oberen ODER-Schaltungsblock 32 in Reihe geschaltet ist. Auf diese Weise muß wenigstens ein Transistor im unteren Schaltungsblock 30 und wenigstens einer im oberen Schaltungsblock 32 leitend geschaltet sein, bevor Strom von der Quelle $V_{CC}$ über den Lastwiderstand L und durch den oberen Block von ODER-Schaltungen 32 sowie den unteren Block von ODER-Schaltungen 30 fließen kann. Wenn ein Strom durch den Lasttransistor L fließt, wird das Potential am Ausgangsanschluß 35 reduziert. Wenn z. B. der logische Wert der Eingangsspannung AB zum Transistor 23' größer ist als derjenige der Referenzspannung REF 2, der Eingangsspannung zum Transistor 25', dann wird der Transistor 23' leitend geschaltet. Wenn gleichzeitig die

logische Eingangsspannung $\overline{C}_0$ zum Transistor 50 größer ist als die Referenzspannung REF 1 am Transistor 26', wird der Transistor 50 leitend geschaltet. Eine Strombahn wird dann gebildet von der Quelle $V_{CC}$ über den Lastwiderstand L, den oberen Transistor 23' und den unteren Transistor 50 zur Stromquelle 40', so daß sich der Ausgang am Ausgangsanschluß 35 von einer relativ hohen Spannung, die anliegt, wenn alle Transistoren in der oberen oder alle Transistoren in der unteren Gruppe abgeschaltet sind, zu einer relativ niedrigen logischen Spannung ändert.

Die die Referenzspannungen REF 1 und REF 2 liefernden bipolaren Transistoren 25' und 26' liegen in einer dritten isolierten epitaxialen Mulde 34, die in Fig. 2A gezeigt ist. Die epitaxiale Mulde 34 kann noch andere Transistoren enthalten, an deren Basen andere Referenzspannungen REF 3, REF 4 und REF 5 angelegt werden, um beispielsweise Referenzpotentiale an Referenztransistoren in anderen PLA-Schaltungen zu liefern. Die Kollektoren der Transistoren in der epitaxialen Mulde 34 sind gemeinsam ähnlich geschaltet wie die Kollektoren für die Transistoren in den oben beschriebenen epitaxialen Mulden 30 und 32.

Bei der in den Fig. 2A, 2b und 2C gezeigten Anordnung der PLA-Schaltungen sind also die bei herkömmlichen Schaltungen, wie sie in Fig. 1A gezeigt sind, üblichen Stromquellen 41, 42, 43 und 44 nicht mehr nötig. Das Geschwindigkeits-/Leistungsprodukt der in Fig. 2A gezeigten PLA-Schaltung wird gegenüber dem Produkt einer herkömmlichen Schaltung, wie sie in Fig. 1A gezeigt ist, um ungefähr den Faktor 10 verbessert. Das entscheidende Merkmal der in Fig. 2A gezeigten verbesserten PLA-Schaltung ist der Wegfall der ODER-Schaltungsgruppe 6 der Fig. 1A durch die in den Fig. 2A, 2B und 2C mit dem Buchstaben E gekennzeichnete Phantom-ODER-Schaltung, die effektiv die ODER-Schaltungsgruppe 6 mit der Suchschaltungsgruppe 1 mischt. Bezogen auf die bipolaren PLA-Schaltungen herkömmlicher Art benötigt die resultierende PLA-Schaltung weniger Chipfläche.

## Patentansprüche

1. Integrierte programmierbare logische Schaltungsanordnung (PLA), bestehend aus einem ODER-Block (30) mit einer dazugehörigen Stromquelle (40') und einem Suchgruppen-Block (32), wobei sowohl die Schaltungen des ODER-Blocks, des Suchgruppen-Blocks als auch der Stromquelle aus bipolaren Transistoren bestehen, dadurch gekennzeichnet, daß jeder Block (30, 32) in seiner eigenen epitaxialen Mulde im Halbleitersubstrat isoliert angeordnet ist, die als gemeinsamer Kollektor für die bipolaren Transistoren dient, daß die Emitter der bipolaren Transistoren in jedem der beiden Blöcke (30, 32) selektiv mit einer für den Block gemeinsamen Emitterleitung (22', 33) verbunden sind, daß die Emitterleitung (22') des ODER-Blocks (30) mit der Stromquelle (40') verbunden ist, daß die Emitterleitung (33) des Suchgruppen-Blocks (32) mit der gemeinsamen Kollektormulde des ODER-Blocks (30) verbunden ist, und daß ein Ausgang (35) an die gemeinsame Kollektormulde des Suchgruppen-Blocks (32) angeschlossen ist, so daß die logische Funktion des ODER-Blocks (30) und diejenige des Suchgruppen-Blocks (32) an dem Ausgang (35) des Suchgruppen-Blocks (32) kombiniert ist.

2. Programmierbare logische Schaltungsanordnung nach Anspruch 1, dadurch gekennzeichnet, daß die Anordnung der bipolaren Transistoren eine stromgeschaltete logische Verbindung bildet, worin eine parallele Gruppe von Transistoren (20', 21' und 50) im ODER-Block (30) mit einer parallelen Gruppe von Transistoren (23', 24' und 52) im Suchgruppen-Block (32) in Reihe geschaltet ist.

3. Programmierbare logische Schaltungsanordnung nach Anspruch 2, dadurch gekennzeichnet, daß die Basen entsprechender Transistoren aus dem ersten und zweiten epitaxialen Bereich gemeinsam an eine Eingangssignalquelle angeschlossen sind.

4. Programmierbare logische Schaltungsanordnung nach Anspruch 3, dadurch gekennzeichnet, daß zur Bildung von Referenzspannungen (REF1 und REF2) bipolare Transistoren (25' und 26') in einer dritten isolierten epitaxialen Mulde (34) angeordnet sind.

5. Programmierbare logische Schaltungsanordnung nach Anspruch 4, dadurch gekennzeichnet, daß wenigstens ein Transistor im ODER-Block (30) und wenigstens einer im Suchgruppen-Block (32) leitend ist, bevor Strom von der Quelle ($V_{CC}$) über einen Lastwiderstand (L) durch die beiden Blöcke fließt.

## Claims

1. Integrated PLA, consisting of an OR array (30) with an associated current source (40'), and a search group array (32), the circuits of the OR array, of the search group array, as well as of the current source consisting of bipolar transistors, characterized in that each block (30, 32) is isolated in its own epitaxial region in the semiconductor substrate which is used as a common collector for the bipolar transistors, that the emitters of the bipolar transistors are selectively connected in each of the two arrays (30, 32) to an emitter line (22', 33) common for the array, that the emitter line (22') of the OR array (30) is connected to the current source (40'), that the emitter line (33) of the search group array (32) is connected to the common collector region of the OR array (30), and that an output (35) is connected to the common collector region of the search group array (32) so that the logic function

of the OR array (30) and that of the search group array (32) are combined at the output (35) of the search group array (32).

2. PLA as claimed in claim 1, characterized in that the arrangement of the bipolar transistors forms a conductive logic connection, where a parallel group of transistors (20', 21' and 50) is seriesarranged in the OR array (30) with a parallel group of transistors (23', 24' and 52) in the search group array (32).

3. PLA as claimed in claim 2, characterized in that the bases of corresponding transistors from the first and second epitaxial region are jointly connected to an input signal source.

4. PLA as claimed in claim 3, characterized in that for forming reference voltages (REF1 and REF2) bipolar transistors (25' and 26') are arranged in the third isolated epitaxial region (34).

5. PLA as claimed in claim 4, characterized in that at least one transistor in the OR array (30), and at least one in the search group array (32) is conductive before current flows from the source ($V_{CC}$) via a load resistor (L) through the two arrays.

**Revendications**

1. Circuit logique programmable intégré (PLA) comportant un ensemble OU (30) avec sa source de courant associé (40') et un ensemble de groupes de recherche (32), les circuits de l'ensemble OU, de l'ensemble des groupes de recherche, ainsi que ceux de la source de courant étant constitués de transistors bipolaires, caractérisé en ce que chaque ensemble (30, 32) est disposé, de façon isolée, dans le substrat semi-conducteur dans sa propre région épitaxiale que sert de collecteur commun pour les transistors bipolaires, en ce que les émetteurs des transistors dans chacun des deux ensembles (30, 32) sont sélectivement connecté à une ligne d'émetteur (22', 33) que leur est commune, en ce que la ligne d'émetteur (22') de l'ensemble OU (30) est connectée à la source de courant (40'), en ce que la ligne d'émetteur (33) de l'ensemble de groupes de recherche (32) est connectée à la région de collecteur commune de l'ensemble OU (30), et en ce qu'une sortie (35) est connectée à la région de collecteur commune de l'ensemble de groupes de recherche (32) de telle sorte que la fonction logique de l'ensemble OU (30) et celle de l'ensemble de groupes de recherche (32) soient combinées à la sortie (35) de l'ensemble de groupes de recherche (32).

2. Circuit logique programmable selon la revendication 1, caractérisé en ce que l'arrangement des transistors bipolaires forme une connexion logique conductrice, dans laquelle un groupe de transistors en parallèle (20', 21' et 50) dans l'ensemble OU (30) est connecté en série à un groupe de transistors en parallèle (23', 24' et 52) dans l'ensemble de groupes de recherche (32).

3. Circuit logique programmable selon la revendication 2, caractérisé en ce que les bases des transistors correspondants des première et seconde régions épitaxiales sont connectées en commun, à une source de signaux d'entrée.

4. Circuit logique programmable selon la revendication 3, caractérisé en ce que des transistors bipolaires (25' et 26') sont disposés dans une troisième région épitaxiale isolée (34) pour générer des tensions de référence (REF1 et REF2).

5. Circuit logique programmable selon la revendication 4, caractérisé en ce qu'au moins un transistor est conducteur dans l'ensemble OU (30) et au moins un transistor est conducteur dans l'ensemble des groupes de recherche (32) avant qu'un courant issu de la source VCC ne circule dans une résistance de charge (L) à travers les deux ensembles.

VOM DEKODIERER

**FIG. 1A**

**FIG. 1B**

$Q1 \cdot \overline{A}B + A\overline{B} + \overline{C}_0$

$\overline{Q1} \cdot \overline{\overline{A}B + A\overline{B} + \overline{C}_0}$

$Q2 \cdot AB + \overline{A}\overline{B} + C_0$

$\overline{Q2} \cdot \overline{AB + \overline{A}\overline{B} + C_0}$

$S_0 \cdot \overline{Q}1 + \overline{Q}2$

0 017 668

REF5 $V_{CC}$ REF4 REF3 REF2 REF1 VOM DEKODIERER $\overline{A}B$ $A\overline{B}$ 32 $\overline{A}\overline{B}$ $C_0$ $\overline{C}_0$ L $V_{CC}$ 35

AB 23' 25' AB 24' 52 Epi AUSGANG

E DOT OR 33 $I_S$

26' 20' 21' 50 $I_S$

34 30' 22' 40'

**FIG. 2A**

$V_{CC}$ L 35 $\overline{AB+\overline{A}\overline{B}+C_0}+\overline{\overline{A}B+A\overline{B}+\overline{C}_0}$ $V_{CC}$

AB 23' $\overline{A}\overline{B}$ 24' $C_0$ 52 REF 2 25'

E $\overline{\overline{A}B+A\overline{B}+\overline{C}_0}$

$\overline{A}B$ 20' $A\overline{B}$ 21' $\overline{C}_0$ 50 REF 1 26' $V_{CC}$

40'

**FIG. 2B**

$C_0$ 32 L $V_{CC}$

$\overline{A}\overline{B}$ $S_0 = \overline{AB+\overline{A}\overline{B}+C_0}+\overline{\overline{A}B+A\overline{B}+\overline{C}_0}$

AB "E" $V_{CC}$

$\overline{C}_0$ 30

$A\overline{B}$

$\overline{A}B$

40' $I_S$

**FIG. 2C**

0 017 668